(19)

Europäisches
Patentamt
European
Patent Office
Office européen
des brevets

(11)  **EP 4 040 170 A1**

(12)  **EUROPEAN PATENT APPLICATION**
published in accordance with Art. 153(4) EPC

(43) Date of publication:
**10.08.2022 Bulletin 2022/32**

(21) Application number: **20870960.0**

(22) Date of filing: **17.08.2020**

(51) International Patent Classification (IPC):
**G01R 27/26** (2006.01)    **H01H 9/54** (2006.01)
**G01R 31/00** (2006.01)

(52) Cooperative Patent Classification (CPC):
**G01R 27/26; G01R 31/00; H01H 9/54**

(86) International application number:
**PCT/JP2020/030956**

(87) International publication number:
**WO 2021/065219 (08.04.2021 Gazette 2021/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.10.2019 JP 2019181090**

(71) Applicant: HITACHI INDUSTRIAL EQUIPMENT
SYSTEMS CO., LTD.
Tokyo 101-0022 (JP)

(72) Inventors:
• **SATO Takashi**
  **Tokyo 100-8280 (JP)**
• **SATOU Shindai**
  **Tokyo 101-0022 (JP)**
• **SHISHIDO Masanori**
  **Tokyo 101-0022 (JP)**
• **KOBAYASHI Masato**
  **Tokyo 101-0022 (JP)**

(74) Representative: **MERH-IP Matias Erny Reichl
Hoffmann
Patentanwälte PartG mbB
Paul-Heyse-Strasse 29
80336 München (DE)**

(54)  **POWER CAPACITOR ELECTROSTATIC CAPACITANCE MEASUREMENT DEVICE AND
POWER CAPACITOR ELECTROSTATIC CAPACITANCE MEASUREMENT METHOD**

(57)    The present invention provides a device and a method for measuring an electrostatic capacitance of a power capacitor that enable minimization of decrease in reliability and minimization of errors in electrostatic capacitance measurements on the power capacitor. In the present invention, a charge circuit includes a power capacitor 16, a DC power supply 500 for charging the power capacitor 16, and a charge switch 501 for making and breaking the connection between the DC power supply 500 and the power capacitor 16. Current sensors 504, 505 are installed in the charge circuit to detect a charging current for the power capacitor 16. The electrostatic capacitance of the power capacitor 16 is measured from first time T1, second time T2, and a time lag between the first time T1 and the second time T2. The first time T1 is required from a start of charging the power capacitor 16 until the current sensor 504 detects a first current value I1. The second time T2 is required from a start of charging the power capacitor 16 until the current sensor 505 detects a second current value 12.

*FIG. 4*

EP 4 040 170 A1

## Description

Technical Field

The present invention relates to a device and a method for measuring an electrostatic capacitance of a power capacitor used in switchgear or the like.

Background Art

The switchgear includes a vacuum breaker. The vacuum breaker is operated by an electromagnetic operating mechanism. A power capacitor is used as an electromagnetic operating mechanism to operate the vacuum breaker. For measuring an electrostatic capacitance of the power capacitor, charging and discharging lead wires should be removed from the power capacitor before the electrostatic capacitance is measured by a capacitance meter. This has required a shutdown of the equipment.

One technique to solve this is disclosed in PTL 1, for example. In PTL 1, a discharge circuit connected in parallel to a power capacitor causes the power capacitor to discharge for a fixed time period, and the voltage of the power capacitor at this time is measured for measurement of electrostatic capacitance.

Citation List

Patent Literature

PTL 1: WO2010/150599

Summary of Invention

Technical Problem

In the technique disclosed in PTL 1, however, because the discharge circuit is separately connected in parallel to the power capacitor for measurement of electrostatic capacitance of the power capacitor, there has been a risk of a malfunction associated with an addition of the discharge circuit, which raises a problem of decrease in reliability.

Further, if variations in initial voltage of the power capacitor occur when the discharge circuit is connected, variations in voltage value of the power capacitor also occur after the discharge circuit has discharged for a fixed time period, and this has resulted in a problem of occurrence of errors in electrostatic capacitance measurements on the power capacitor.

It is an object of the present invention to provide a power capacitor electrostatic capacitance measurement device and a power capacitor electrostatic capacitance measurement method that enable minimization of decrease in reliability and minimization of errors in electrostatic capacitance measurements on a power capacitor.

Solution to Problem

To achieve the above object, an aspect of the present invention provides a power capacitor electrostatic capacitance measurement device that includes: a charge circuit including a power capacitor, a power supply for charging the power capacitor, and a charge switch for making and breaking connection between the power supply and the power capacitor; and a current sensor installed in the charge circuit to detect a charging current for the power capacitor. An electrostatic capacitance of the power capacitor is measured from a first time period, a second time period, and a time lag between the first time period and the second time period, the first time period being required from a start of charging the power capacitor until the current sensor detects a first current value, and the second time period being required from a start of charging the power capacitor until the current sensor detects a second current value.

Advantageous Effects of Invention

According to the present invention, it is possible to provide a power capacitor electrostatic capacitance measurement device and a power capacitor electrostatic capacitance measurement method that enable minimization of decrease in reliability and minimization of errors in electrostatic capacitance measurements on a power capacitor. Brief Description of Drawings

Figure 1 is a vertical section view of switchgear including a vacuum breaker according to Example 1.
Figure 2 is a diagram illustrating a detailed configuration of the vacuum breaker according to Example 1.
Figure 3 is a vertical front section view of the vacuum breaker according to Example 1.
Figure 4 is a diagram illustrating a charge and discharge circuit according to Example 1.
Figure 5 is a block diagram of an accumulation and comparison section according to Example 1.
Figure 6 is a diagram illustrating time characteristics of voltage and current when the power capacitor according to Example 1 is charged.
Figure 7 is a diagram illustrating time characteristics of voltage and current when the power capacitor according to Example 1 is charged.
Figure 8 is a diagram illustrating time characteristics of voltage and current when the power capacitor according to Example 1 is charged.
Figure 9 is a block diagram of an accumulation and comparison section according to Example 2.
Figure 10 is a perspective view illustrating a configuration of a current sensor according to Example 3.
Figure 11 is a perspective view illustrating a configuration of a current sensor according to Example 4.
Figure 12 is a perspective view illustrating a configuration of a current sensor according to Example 5.
Description of Embodiments

Examples suitable for implementing the present invention will now be described with reference to the accompanying drawings. It should be understood that the following is merely illustrative of examples and the contents of the invention are not intended to be limited to the following specific aspects. Modifications can of course be made to the present invention to implement various aspects including the following aspects.

<Example 1>

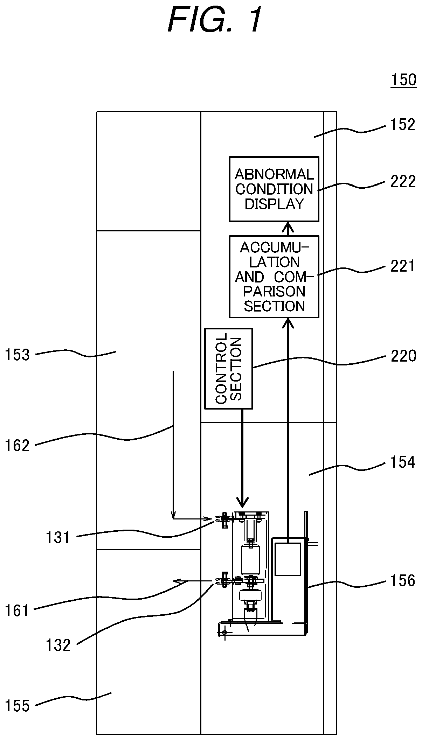

Example 1 will be described with reference to Figure 1 to Figure 7.
Figure 1 is a vertical section view of switchgear including a vacuum breaker according to Example 1 of the present invention.
As illustrated in Figure 1, the switchgear 150 is partitioned into a breaker chamber 154, a measuring instrument chamber 152 located above the breaker chamber 154, and a bus chamber 153 and a cable chamber 155 both of which are located at the back of the breaker chamber 154 and the measuring instrument chamber 152.
A vacuum breaker 156 is installed in the breaker chamber 154.
The measuring instrument chamber 152 accommodates: a control section 220 that controls opening and closing of a main contact of the vacuum breaker 156; an accumulation and comparison section 221 that determines whether or not anomaly and what type of anomaly occurs in the conditions of the vacuum breaker 156; and an abnormal condition display section 222 that provides indications for abnormal conditions of the vacuum breaker 156 by lighted lamp (or turning off the lamp), images, audio, and/or the like when the accumulation and comparison section 221 determines that the vacuum breaker 156 is in abnormal conditions. The accumulation and comparison section 221 sequentially accumulates measurement results on power capacitor electrostatic capacitances, and compares a newly measured result to the previously accumulated results in order to detect anomaly.
The bus chamber 153 accommodates a bus 162 and a wiring cable 161. The bus 162 is electrically connected to a fixed contact 7 of a vacuum valve 9 in the vacuum breaker 156. The wiring cable 161 is electrically connected to a movable contact 8 of the vacuum valve 9 in the vacuum breaker 156.
And, a door is mounted in the front of a housing (on the right side in Figure 1) of the switchgear 150. When the door is opened, an operating panel is exposed which includes switches installed in the front of the vacuum breaker 156. At the time of maintenance check, a worker is allowed to open the door and pull out the vacuum breaker 156.

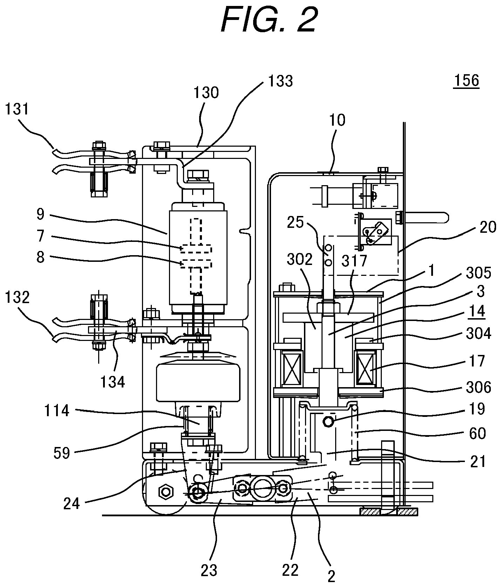

A detailed configuration of the vacuum breaker 156 will now be described. Figure 2 is a diagram illustrating the detailed configuration of the vacuum breaker according to Example 1.
As illustrated in Figure 2, the vacuum breaker 156 in this example mainly includes the vacuum valve 9, an electromagnetic operating device 1, and a link mechanism 2. The vacuum valve 9 has a main circuit make-and-break portion (the fixed contact 7 and the movable contact 8) installed therein. The electromagnetic operating device 1 operates the make and break of the main circuit make-and-break portion (the fixed contact 7 and the movable contact 8) of the vacuum valve 9. The link mechanism 2 couples the electromagnetic operating device 1 and the vacuum valve 9 to each other.
The electromagnetic operating device 1 mainly includes an electromagnet 14 in which a movable core 302 and a fixed core 306 placed face to face, and a casing 305 houses a permanent magnet 304, an electromagnetic coil 17 (load), an electromagnetic operating device side rod 3 and a movable flat plate 317, the rod 3 and movable flat plate 317 being coupled to the movable core 302 moving up and down in the vertical direction. The electromagnetic operating device 1 is connected to a first lever 22 via a pin 19, a coupling component 21, and a link mechanism 2. All of them are placed within the housing 10.
Also, when excitation current is provided to the electromagnetic coil 17, the movable core 302 moves downward. When the electromagnetic operating device side rod 3 coupled to the movable core 302 moves downward, a second lever 23 rotates, and in turn a coupling component 24 and a vacuum valve side rod 114 move upward to allow the fixed contact 7 and the movable contact 8 in the vacuum valve 9 to come into contact with each other.
In an insulation frame 130, the main circuit which is composed of disconnectors 131, 132, a fixed conductor 133, the vacuum valve 9, and a movable conductor 134, and the vacuum valve side rod 114, a wipe spring 59, a shaft 25, and a break spring 60 are included in order to drive the movable contact 8 of the vacuum valve 9 to disconnect from the fixed contact 7.
In the turn-on operation of the vacuum breaker 156, the wipe spring 59 and the break spring 60 are compressed to accumulate elastic energy by which break operation is performed. When the make and break portion of the vacuum valve 9 is in the turn-on state, the movable core 302 and the movable flat plate 317 are held by the attractive force of the permanent magnet 304.
In the break operation of the electromagnetically operated vacuum breaker 156, a current opposite in direction to that in the turn-on operation is passed through the electromagnetic coil 17, so that magnetic flux is produced in the direction of counteracting the attractive force of the permanent magnet 304 to thereby release the elastic energy accumulated in the wipe spring 59 and the break spring 60. As a result, the electromagnetic operating device side rod 3 moves upward to open the fixed contact 7 and the movable contact 8 which are placed in the vacuum valve 9.

Upon upward movement of the electromagnetic operating device side rod 3, the shaft 25 moves upward, so that a third lever (not shown) rotates in response to the movement of the shaft 25. The third lever and an auxiliary switch 20 are operated in conjunction with each other, and the auxiliary switch 20 provides both the detection of a state of the make-and-break portion of the vacuum valve 9 and the control over the current flowing in the electromagnetic coil 17. In the on operation, a fourth lever (not shown) rotates about a pin in a counterclockwise direction for movement to a position where letters "ON" in a display panel (not shown) are viewed from the front.

Also, in the above-described auxiliary switch 20, the turn-on operation time and the break operation time of the vacuum breaker 156 are measured based on a time lag between the operation timing of a normally open contact and a normally closed contact which are signal contacts in the auxiliary switch 20 and the timing of a turn-on instruction and a break instruction (opening instruction) which are issued by the control section 220 (see Figure 1). Based on temporal changes in the measured turn-on operation time and the measured break operation time, conditions of the vacuum breaker 156 are determined such as erosion of the fixed contact 7 and the movable contact 8 in the vacuum valve 9, a vacuum leak from the vacuum valve 9, an increase in friction in the drive mechanism of the movable contact 8, and the like.

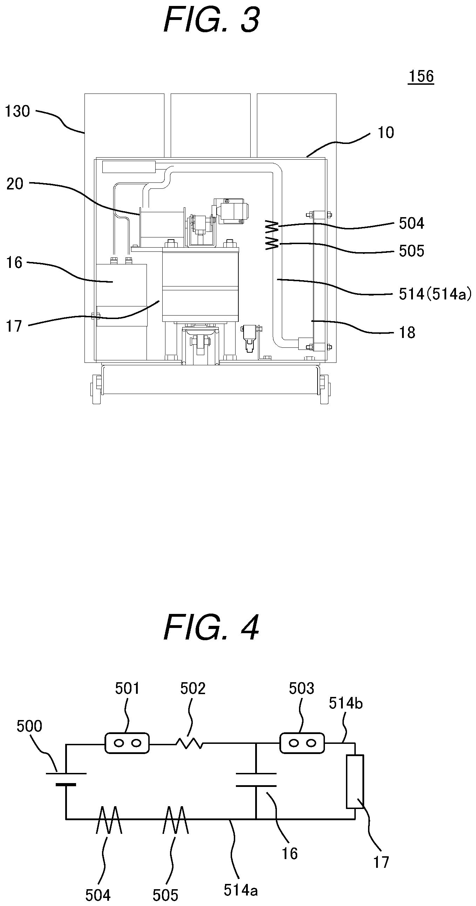

Figure 3 is a vertical front section view of the vacuum breaker 156 according to Example 1. A control substrate 18 vertically extending is secured to the housing 10. Lead wires 514 extend from the control substrate 18, and the auxiliary switch 20, the power capacitor 16, and the electromagnetic coil 17 are connected to the lead wires 514. Current sensors 504, 505 are mounted to a lead wire 514a of the lead wires 514 through which a charging current for the power capacitor 16 flows.

Figure 4 is a diagram illustrating a charge and discharge circuit according to Example 1. The charge and discharge circuit is connected to each piece of equipment through the lead wires 514a, 514b. A charge switch 501, a charge resistance 502, and the power capacitor 16 are connected to a DC power supply 500 (power supply) through the lead wire 514a to form a charge circuit. And, by turning on the charge switch 501, the power capacitor 16 is charged. After the power capacitor 16 is charged, the charge switch 501 is turned off.

Also, a discharge switch 503 and the electromagnetic coil 17 (load) are connected to the power capacitor 16 through the lead wire 514b to form a discharge circuit. By turning on the discharge switch 503, an electric current is provided from the power capacitor 16 to the electromagnetic coil 17 (load) to actuate the electromagnet 14. After the actuation of the electromagnet 14, the discharge switch 503 is turned off, and the charge switch 501 is turned on, thereby re-charging the power capacitor 16. The charging current at this time is measured by the current sensors 504, 505.

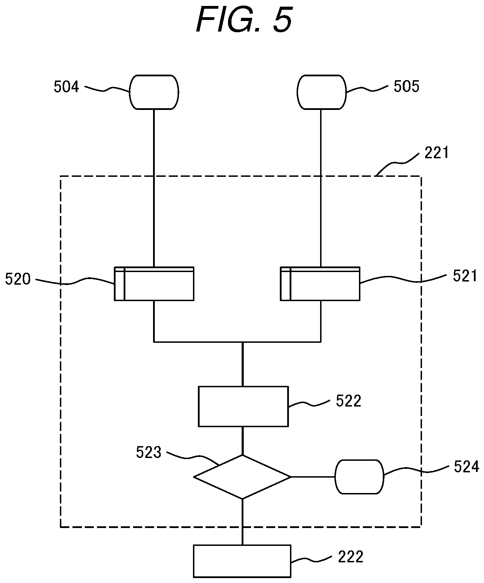

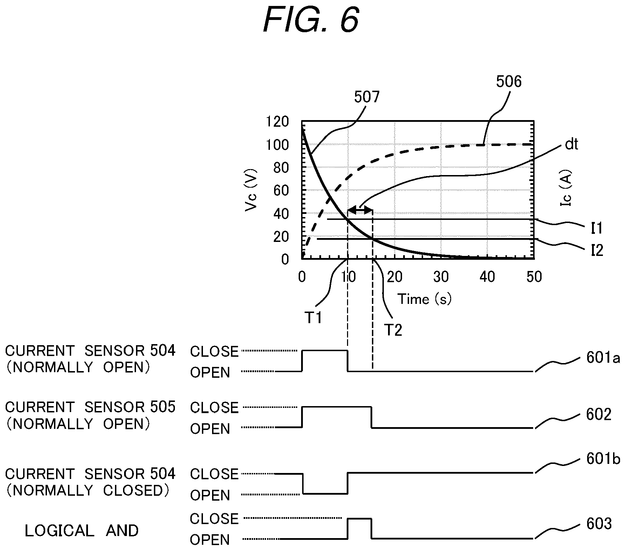

Next, a method of measuring an electrostatic capacitance of the power capacitor 16 will be described with reference to Figures 5 and 6. Figure 5 is a block diagram of the accumulation and comparison section 221 according to Example 1. Figure 6 is a diagram illustrating time characteristics of voltage and current when the power capacitor according to Example 1 is charged.

Figure 5 illustrates an example of using a plurality of digital current sensors. As illustrated in Figure 6, where an initial voltage of the power capacitor is 0V, a power capacitor charging current 507 has characteristics of gradually decreasing from a value obtained by dividing a DC supply voltage by a charge resistance, to 0A with a time constant CR with the passage of time. On the other hand, a power capacitor voltage 506 has characteristics of gradually increasing from 0V to a predetermined DC supply voltage with a time constant CR with the passage of time.

The current sensors 504, 505 detect a charging current that charges the power capacitor 16. Sensors used for the current sensors 504, 505 include normally open contacts which differ from each other in sensitivity to a current value to be detected, for example.

As illustrated in Figure 6, as the power capacitor charging current 507 gradually decreases with a time constant CR, when an output signal 601a of the current sensor 504 (first current sensor) crosses a current value I1 (first current value), switching from closing to opening is made. Likewise, when an output signal 602 of the current sensor 505 (second current sensor) crosses a current value 12, switching from closing to opening is made. The output signal 601a of the current sensor 504 (first current sensor) and the output signal 602 of the current sensor 505 (second current sensor) switch from closing to opening with a time lag dt.

In Example 1, a combination of two current sensors is used. The current sensors 504, 505 are adjusted to switch to digital output when the power capacitor charging current 507 crosses each current value I1, 12.

Then, when the current sensors 504, 505 respectively detect different current values, the sensors switch from closing to opening. And, by measuring a difference between the time at which the current sensor 504 switches from closing to opening and the time at which the current sensor 505 switches from closing to opening, a power capacitor electrostatic capacitance can be calculated.

The detection results of detection of the current sensors 504, 505 are respectively stored in accumulators 520, 521 of the accumulation and comparison section 221.

The accumulator 520 stores a predetermined current value I1 (first current value) as well as a time T1 (time at which the current value I1 is crossed) which corresponds to a first time period required until the current sensor 504 (first current sensor) detects a predetermined current value I1 (first current value) after the start of charging the power capacitor 16.

The accumulator 521 stores a predetermined current value I2 (second current value) as well as a time T2 (time at which the current value I2 is crossed) which corresponds to a second time period required until the current sensor 505 (second current sensor) detects a predetermined current value I2 (second current value) after the start of charging the power capacitor 16.

The current value I1 (first current value) and the current value I2 (second current value) are set at different values from each other. The detection results respectively stored in the accumulators 520, 521 are transmitted to a difference computation section 522.

In the difference computation section 522, an electrostatic capacitance C of the power capacitor 16 is calculated from the current values I1, I2 and a time lag dt between times T1, T2 at which the current values I1, I2 are crossed, by the following equation.

$$C = (1/R) \cdot dt / (\ln(I1/I2))$$

where, if the current values I1, I2 and the charge resistance R are fixed, a power capacitor electrostatic capacitance C is calculated by measuring the time lag dt.

Then, the power capacitor electrostatic capacitance C calculated in the difference computation section 522 is transmitted to a comparator 523 in which the calculated power capacitor electrostatic capacitance C and a predetermined time lag determination value 524 are compared with each other. In the comparator 523, it is determined whether or not the calculated power capacitor electrostatic capacitance C is below the time lag determination value 524. If the calculated power capacitor electrostatic capacitance C is below the time lag determination value 524, an instruction signal for indicating anomaly is output to the abnormal condition display section 222. After reception of the instruction signal, the abnormal condition display section 222 notifies of an abnormal condition of the power capacitor.

In the above-described example, normally open contact sensors are used as both the current sensors 504, 505. However, for example, the current sensor 504 may be a normally closed contact sensor and the current sensor 505 may be a normally open contact sensor so that they have different sensitivities to a current value to be detected by each sensor. As illustrated in Figure 6, as the power capacitor charging current 507 gradually decreases with a time constant CR, when an output signal 601b of the current sensor 504 (first current sensor) reaches 10s, switching from opening to closing is made. Likewise, when an output signal 602 of the current sensor 505 (second current sensor) reaches 15s, switching from closing to opening is made. By monitoring the logical AND 603 of the output signal 601b of the current sensor 504 (first current sensor) and the output signal 602 of the current sensor 505 (second current sensor), a time lag dt can be measured, so that the electrostatic capacitance of the power capacitor 16 is calculated. If the current sensors 504, 505 provide contact outputs, the logical AND 603 is easily obtained by connecting the respective outputs in series.

Also, in this example, the current sensor 504 may be a normally open contact sensor and the current sensor 505 may be a normally closed contact sensor. Specifically, one of the current sensor 504 (first current sensor) and the current sensor 505 (second current sensor) may include a normally closed contact, and the other may include a normally open contact.

In this example, even if the power capacitor 16 has various electrostatic capacitances, the electrostatic capacitance of the power capacitor 16 is capable of being measured.

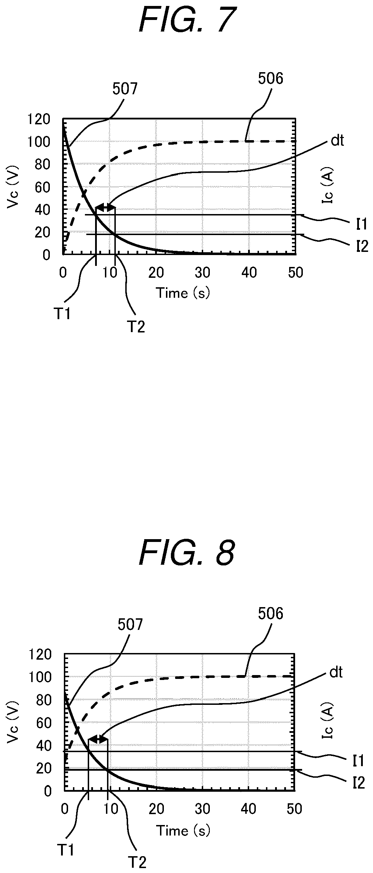

Figure 7 is a diagram illustrating time characteristics of voltage and current when a power capacitor according to Example 1 is charged, which shows the characteristics of the power capacitor having a lower electrostatic capacitance value than the electrostatic capacitance of the power capacitor used in Figure 6. In Figure 6, if the current values I1, I2 are set equally to those in Figure 6, the time lag dt to be calculated becomes smaller in proportion to the electrostatic capacitance of the power capacitor.

Figure 8 is a diagram illustrating time characteristics of voltage and current when a power capacitor according to Example 1 is charged, which shows the characteristics of the power capacitor having an electrostatic capacitance when the initial voltage of the power capacitor 16 has a higher value than that in Figure 7. In this case, both times T1, T2 move toward zero, but the time lag dt between them is kept at the same value as Figure 7. Because of this, the electrostatic capacitance can be measured in the condition of minimized variations in electrostatic capacitances due to different initial voltages of the power capacitor 16.

According to this example, a time lag dt between the times T1, T2 at which the power capacitor charging current 507 crosses the current values I1, I2 is measured. This enables calculation of the electrostatic capacitance of the power capacitor 16 after the influence of the initial voltage of the power capacitor is minimized.

According to this example, also, because of no need to install an additional discharge circuit in order to measure the electrostatic capacitance of the power capacitor, it is possible to provide a power capacitor electrostatic capacitance measurement device inhibited from decreasing the reliability.

<Example 2>

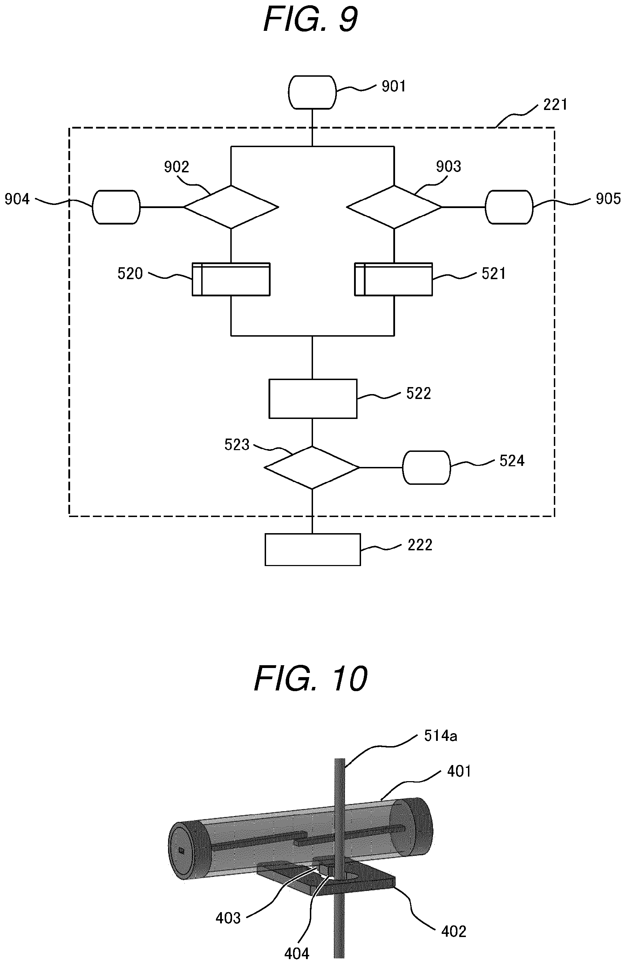

Next, Example 2 will be described with reference to Figure 9. Like reference signs are used to indicate common configurations with Example 1, and a detailed explanation thereof is omitted. Figure 9 is a block diagram of an accumulation and comparison section 221 according to Example 2. A difference from Example 1 is that the number of installed current sensors is one.

In Example 2, only one current sensor capable of continuously measuring electric currents is installed, and a microcomputer continuously monitors the output of the current sensor, and a time lag between when the power capacitor charging current 507 crosses a current value I1 and when it crosses a current value I2 is calculated.

Figure 9 illustrates an example of using a single analog current sensor. In Figure 9, detection values continuously detected by a current sensor 901 are transmitted to comparators 902, 903, and then respectively compared with current determination values 904, 905. The current values I1, I2 are stored respectively in the current determination values 904, 905, so that the detection values continuously detected by the current sensor 901 are compared with the current values I1, 12.

The comparator 902 determines a time at which each analog current value continuously output from the current sensor 901 reaches the current value I1 (first current value), which is then stored in the accumulator 520. Likewise, the comparator 903 determines a time at which each analog current value continuously output from the current sensor 901 reaches the current value I2 (second current value), which is then stored in the accumulator 521. The subsequent processing is similar to Example 1, and a detailed explanation is omitted.

According to this example, a time lag dt between when the power capacitor charging current 507 crosses the current value I1 and when it crosses the current value I2 is calculated. This enables calculation of the electrostatic capacitance of the power capacitor 16 after the influence of the initial voltage of the power capacitor is minimized. Further, because the calculation of the electrostatic capacitance of the power capacitor 16 is accomplished by use of a single current sensor, this results in a reduction in cost.

Further, according to this example, because of no need to install an additional discharge circuit in order to measure the electrostatic capacitance of the power capacitor, it is possible to provide a power capacitor electrostatic capacitance measurement device inhibited from decreasing the reliability.

<Example 3>

Next, Example 3 will be described with reference to Figure 10. Figure 10 is a perspective view illustrating a configuration of a current sensor according to Example 3.

In Figure 10, the current sensor in Example 3 includes a reed switch 401 and a toroidal magnetic core 402. The toroidal magnetic core 402 has a slit portion 403 and a hollow portion 404 formed therein, the slit portion 403 being open outward in the radial direction in a portion of the outer perimeter of the toroidal magnetic core 402, the hollow portion 404 being formed to communicate with the slit portion 403 in the radial direction. In the hollow portion 404, the lead wire 514 is placed to pass through the hollow portion 404. A gap in the slit portion 403 is sized to be larger than the diameter of the lead wire 514, and the lead wire 514 is inserted through the slit portion 403 to be located in the hollow portion 404. The hollow portion 404 is also sized to be larger than the diameter of the lead wire 514.

The current sensor causes the reed switch 401 to be operated by magnetic flux leaking from the slit portion 403.

The envelope of the reed switch 401 is made of a glass tube, and two ferromagnetic reeds are placed within the glass tube.

When the reed switch 401 has a normally open contact, the two ferromagnetic reeds face each other at a certain contact spacing. Upon application of a magnetic field to the normally open contact reeds from outside, the reeds become magnetized, so that the facing free ends attract and come into contact with each other and thus the circuit is closed. If the magnetic field is eliminated, the circuit can be opened by elasticity of the reeds.

When the reed switch 401 has a normally closed contact, the two ferromagnetic reeds face each other with the contacts in contact with each other. Upon application of a magnetic field to the normally closed contact reeds from outside, the reeds become magnetized, so that the facing free ends move away from each other and thus the circuit can be opened. If the magnetic field is eliminated, the circuit can be closed by elasticity of the reeds.

For measurement of the charging current of the power capacitor 16, in Example 3, the lead wire 514 is passed through the toroidal magnetic core 402, and a magnetic flux leaking from the slit portion 403 of the toroidal magnetic core 402 magnetizes the reeds of the reed switch 401 placed adjacent to the toroidal magnetic core 402 for actuation. And, in the case of application to Example 1, the two current sensors in Example 3 may be included.

According to Example 3, the current can be measured in a noncontact manner.

Also, according to Example 3, a gap enough for the lead wire 514 to pass therethrough in the lateral direction is formed between the toroidal magnetic core 402 and a portion of the reed switch 401, and also for the slit portion 403 a width enough for the lead wire 514 to pass therethrough in the lateral direction is ensured. Thereby, a current sensor may be later installed without removal of the existing lead wire 514.

Further, according to Example 3, the sealed structure makes the reed switch more reliable.

Furthermore, according to Example 3, sensitivity adjustment is made by adjusting the width of the slit portion 403 and/or the gap between the toroidal magnetic core 402 and the reed switch 401.

<Example 4>

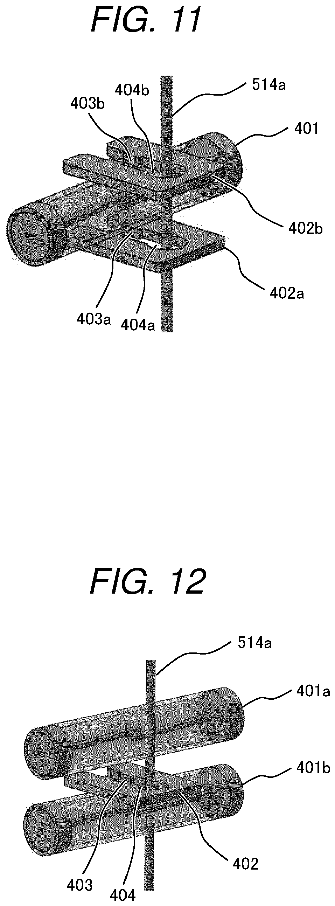

Next, Example 4 will be described with reference to Figure 11. Like reference signs are used to indicate common configurations with Example 3, and a detailed explanation thereof is omitted. Figure 11 is a perspective view illustrating a configuration of a current sensor according to Example 4. A difference from Example 3 is that there are two toroidal magnetic cores.

In Example 4, two toroidal magnetic cores, a first toroidal magnetic core 402a and a second toroidal magnetic core 402b, are included and a reed switch 401 is placed between the first toroidal magnetic core 402a and the second toroidal magnetic core 402b.

The first toroidal magnetic core 402a has a slit portion 403a and a hollow portion 404a formed therein, the slit portion 403a being open outward in the radial direction in a portion of the outer perimeter of the first toroidal magnetic core 402a, the hollow portion 404a being formed to communicate with the slit portion 403a in the radial direction. In the hollow portion 404a, the lead wire 514 is placed to pass through the hollow portion 404a. A gap in the slit portion 403a is sized to be larger than the diameter of the lead wire 514, and the lead wire 514 is inserted through the slit portion 403a to be located in the hollow portion 404a. The hollow portion 404a is also sized to be larger than the diameter of the lead wire 514.

Likewise, the second toroidal magnetic core 402b has a slit portion 403b and a hollow portion 404b formed therein, the slit portion 403b being open outward in the radial direction in a portion of the outer perimeter of the second toroidal magnetic core 402b, the hollow portion 404b being formed to communicate with the slit portion 403b in the radial direction. In the hollow portion 404b, the lead wire 514 is placed to pass through the hollow portion 404b. A gap in the slit portion 403b is sized to be larger than the diameter of the lead wire 514, and the lead wire 514 is inserted through the slit portion 403b to be located in the hollow portion 404b. The hollow portion 404b is also sized to be larger than the diameter of the lead wire 514.

According to Example 3, because the first toroidal magnetic core 402a and the second toroidal magnetic core 402b are placed to sandwich the reed switch 401, an enhanced sensitivity of the current sensor can be achieved.

<Example 5>

Next, Example 5 will be described with reference to Figure 12. Like reference signs are used to indicate common configurations with Example 3, and a detailed explanation thereof is omitted. Figure 12 is a perspective view illustrating a configuration of a current sensor according to Example 5. A difference from Example 3 is that there are two reed switches.

In Example 5, two reed switches, a first reed switch 401a and a second reed switch 401b, are included and a toroidal magnetic core 402 is placed between the first reed switch 401a and the second reed switch 401b.

Where a gap between the first reed switch 401a and the toroidal magnetic core 402 is G1 and a gap between the second reed switch 401b and the toroidal magnetic core 402 is G2, a current value at which the first reed switch 401a is operated and a current value at which the second reed switch 401b is operated are changed by changing the distance between G1 and G2.

In other words, according to Example 5, changing the distance between G1 and G2 may provide two output signals with different sensitivities.

Also, according to Example 5, a further reduction in size can be achieved as compared with the case of installing two current sensors as described in Example 3.

It should be understood that the present invention is not limited to the above examples and is intended to embrace various modifications.

The above examples have been described in detail for the purpose of explaining the present invention clearly, and the present invention is not necessarily limited to including all the components and configurations described above.

Reference Signs List

| | |
|---|---|
| 1 | electromagnetic operating device, |
| 2 | link mechanism, |
| 3 | electromagnetic operating device side rod, |
| 7 | fixed contact, |
| 8 | movable contact, |
| 9 | vacuum valve, |
| 10 | housing, |
| 14 | electromagnet, |
| 16 | power capacitor, |
| 17 | electromagnetic coil, |
| 18 | control substrate, |
| 19 | pin, |
| 20 | auxiliary switch, |
| 21 | coupling component, |
| 22 | first lever, |
| 23 | second lever, |
| 24 | coupling component, |
| 25 | shaft, |
| 59 | wipe spring, |
| 60 | break spring, |
| 114 | vacuum valve side rod, |
| 130 | insulation frame, |
| 131 | disconnector, |
| 132 | disconnector, |
| 133 | fixed conductor, |
| 134 | movable conductor, |
| 150 | switchgear, |
| 152 | measuring instrument chamber, |

153     bus chamber,
154     breaker chamber,
155     cable chamber,
156     vacuum breaker,
161     wiring cable,
162     bus,
220     control section,
221     accumulation and comparison section,
222     abnormal condition display section,
302     movable core,
304     permanent magnet,
305     casing,
306     fixed core,
317     movable flat plate,
401     reed switch,
401a    first reed switch,
401b    second reed switch,
402     toroidal magnetic core,
402a    first toroidal magnetic core,
402b    second toroidal magnetic core,
403     slit portion,
403b    slit portion,
404     hollow portion,
404a    hollow portion,
404b    hollow portion,
500     DC power supply,
501     charge switch,
502     charge resistance,
503     discharge switch,
504     current sensor,
505     current sensor,
506     power capacitor voltage,
507     power capacitor charging current,
514     lead wire,
514a    lead wire,
514b    lead wire,
520     accumulator,
521     accumulator,
522     difference computation section,
523     comparator,
524     time lag determination value,
603     logical AND,
901     current sensor,
902     comparator,
903     comparator,
904     current determination value,
905     current determination value.

**Claims**

1.  A power capacitor electrostatic capacitance measurement device, comprising:

    a charge circuit including a power capacitor, a power supply for charging the power capacitor, and a charge switch for making and breaking connection between the power supply and the power capacitor;
a current sensor installed in the charge circuit to detect a charging current for the power capacitor; and
an accumulation and comparison section that measures an electrostatic capacitance of the power capacitor from a first time period, a second time period, and a time lag between the first time period and the second time period, the first time period being required from a start of charging the power capacitor until the current sensor detects a first current value, and the second time period being required from a start of charging the power capacitor until the current sensor detects a second current value.

2.  The power capacitor electrostatic capacitance measurement device according to claim 1, further comprising a discharge circuit including a load driven by the power capacitor and a discharge switch for making and breaking connection between the load and the power capacitor.

3.  The power capacitor electrostatic capacitance measurement device according to claim 1 or 2, wherein the current sensor includes a first current sensor for measuring the first current value and a second current sensor for measuring the second current value.

4.  The power capacitor electrostatic capacitance measurement device according to claim 3, wherein the first current sensor and the second current sensor differ in sensitivity to a current value to be detected.

5.  The power capacitor electrostatic capacitance measurement device according to claim 4, wherein the first current sensor and the second current sensor are designed to switch to digital output, one of the first current sensor and the second current sensor includes a normally closed contact, and the other includes a normally open contact.

6.  The power capacitor electrostatic capacitance measurement device according to claim 1 or 2, wherein output of the current sensor is analog current values to be continuously output.

7.  The power capacitor electrostatic capacitance measurement device according to claim 1 or 2,

    wherein the current sensor includes a toroidal magnetic core and a reed switch,
    the toroidal magnetic core includes a slit portion that is open outward in a radial direction in a portion of an outer perimeter, and a hollow portion that communicates with the slit portion in the radial direction and allows a lead wire to be placed therein, and

a magnetic flux leaking from the slit portion operates the reed switch.

8. The power capacitor electrostatic capacitance measurement device according to claim 7,

wherein the toroidal magnetic core includes a first toroidal magnetic core and a second toroidal magnetic core, and

the reed switch is placed between the first toroidal magnetic core and the second toroidal magnetic core.

9. The power capacitor electrostatic capacitance measurement device according to claim 7,

wherein the reed switch includes a first reed switch and a second reed switch, and

the toroidal magnetic core is placed between the first reed switch and the second reed switch.

10. A power capacitor electrostatic capacitance measurement method, comprising the steps of:

forming a charge circuit including a power capacitor, a power supply for charging the power capacitor, and a charge switch for making and breaking connection between the power supply and the power capacitor; and

measuring an electrostatic capacitance of the power capacitor from a first time period, a second time period, and a time lag between the first time period and the second time period, the first time period being required from a start of charging the power capacitor until a current sensor installed in the charge circuit detects a first current value, and the second time period being required from a start of charging the power capacitor until the current sensor detects a second current value.

# FIG. 1

EP 4 040 170 A1

# FIG. 2

11

# FIG. 3

156

130

20

16

17

10

504

505

514(514a)

18

# FIG. 4

501  502  503  514b

500

504  505  514a  16  17

# FIG. 5

# FIG. 6

## FIG. 7

## FIG. 8

## FIG. 9

## FIG. 10

## FIG. 11

## FIG. 12

## INTERNATIONAL SEARCH REPORT

| International application No. |
|---|
| PCT/JP2020/030956 |

**A. CLASSIFICATION OF SUBJECT MATTER**
Int.Cl. G01R27/26(2006.01)i, H01H9/54(2006.01)i, G01R31/00(2006.01)i
FI: G01R27/26C, G01R31/00, H01H9/54H

According to International Patent Classification (IPC) or to both national classification and IPC

**B. FIELDS SEARCHED**

Minimum documentation searched (classification system followed by classification symbols)
Int.Cl. G01R27/26, H01H9/54, G01R31/00

| Documentation searched other than minimum documentation to the extent that such documents are included in the fields searched | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 9-257856 A (HONDA MOTOR CO., LTD.) 03 October 1997 (1997-10-03), entire text, all drawings | 1-10 |
| A | JP 2011-75507 A (TOYO ELECTRIC MFG CO., LTD.) 14 April 2011 (2011-04-14), entire text, all drawings | 1-10 |
| A | JP 2000-78774 A (SIEMENS AG) 14 March 2000 (2000-03-14), entire text, all drawings | 1-10 |
| A | JP 2015-197310 A (HIOKI E.E. CORPORATION) 09 November 2015 (2015-11-09), entire text, all drawings | 1-10 |
| A | JP 60-502227 A (JOHNSON SERVICE COMPANY) 19 December 1985 (1985-12-19), entire text, all drawings | 1-10 |

☒ Further documents are listed in the continuation of Box C. ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 October 2020 | 02 November 2020 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

| International application No. |
|---|
| PCT/JP2020/030956 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2012-202687 A (TAMURA CORPORATION) 22 October 2012 (2012-10-22), entire text, all drawings | 1-10 |
| A | WO 2010/113223 A1 (SUMITOMO HEAVY INDUSTRIES, LTD.) 07 October 2010 (2010-10-07), entire text, all drawings | 1-10 |
| A | JP 62-123367 A (ADVANTEST CORPORATION) 04 June 1987 (1987-06-04), entire text, all drawings | 1-10 |
| A | JP 10-221396 A (MURATA MANUFACTURING CO., LTD.) 21 August 1998 (1998-08-21), whole document, all drawings | 1-10 |
| A | US 2015/0028887 A1 (ATMEL CORPORATION) 29 January 2015 (2015-01-29), entire text, all drawings | 1-10 |
| A | US 2018/0156853 A1 (RAYDIUM SEMICONDUCTOR CORPORATION) 07 June 2018 (2018-06-07), entire text, all drawings | 1-10 |

Form PCT/ISA/210 (second sheet) (January 2015)

INTERNATIONAL SEARCH REPORT
Information on patent family members

International application No.

PCT/JP2020/030956

| JP 9-257856 A | 03 October 1997 | (Family: none) |
| JP 2011-75507 A | 14 April 2011 | (Family: none) |
| JP 2000-78774 A | 14 March 2000 | US 6580279 B1<br>entire text, all drawings<br>EP 0961383 A1 |
| JP 2015-197310 A | 09 November 2015 | (Family: none) |
| JP 60-502227 A | 19 December 1985 | US 4558274 A<br>entire text, all drawings<br>WO 85/01356 A1 |
| JP 2012-202687 A | 22 October 2012 | (Family: none) |
| WO 2010/113223 A1 | 07 October 2010 | US 2012/0038327 A1<br>entire text, all drawings<br>EP 2418504 A1<br>CN 102369449 A |
| JP 62-123367 A | 04 June 1987 | (Family: none) |
| JP 10-221396 A | 21 August 1998 | (Family: none) |
| US 2015/0028887 A1 | 29 January 2015 | DE 102014214801 A1<br>entire text, all drawings |
| US 2018/0156853 A1 | 07 June 2018 | CN 108152598 A<br>entire text, all drawings |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010150599 A